(19) **Europäisches Patentamt**

**European Patent Office**

**Office européen des brevets**

(11) **EP 4 087 081 A1**

(12) **EUROPEAN PATENT APPLICATION**

published in accordance with Art. 153(4) EPC

(43) Date of publication:
**09.11.2022 Bulletin 2022/45**

(21) Application number: **20909868.0**

(22) Date of filing: **12.10.2020**

(51) International Patent Classification (IPC):
*H02J 3/00* (2006.01)     *G16Y 20/30* (2020.01)

(86) International application number:
**PCT/RU2020/000536**

(87) International publication number:
**WO 2021/137720 (08.07.2021 Gazette 2021/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.12.2019 RU 2019145082**

(71) Applicants:
• **Efimenkova, Olga Valentinovna**
  **Moscow, 119331 (RU)**

• **de la Cuesta Barosso, Olga**
  **Moscow, 117393 (RU)**

(72) Inventors:
• **Efimenkova, Olga Valentinovna**
  **Moscow, 119331 (RU)**
• **de la Cuesta Barosso, Olga**
  **Moscow, 117393 (RU)**

(74) Representative: **Hellmich, Wolfgang**
  **European Patent and Trademark Attorney**
  **Lortzingstrasse 9 / 2. Stock**
  **81241 München (DE)**

(54) **METHOD FOR MONITORING AND MANAGING ELECTRICAL POWER CONSUMPTION**

(57)     The invention relates to managing electrical power consumption in the home. Claimed is a system which includes the electric power grid in a home, means for measuring power, and means for controlling load. The home grid is fed by an external grid and is configured in the form of individual lines having individual shutoff devices on supply lines for low priority, medium priority, high priority and extra high priority consumers. The medium priority consumers are connected to a supply line such as to allow phase switching, deactivation and deferral of the operation of a consumer to a different designated time. Sensors for monitoring and transmitting instanta- neous current and voltage values to a microcontroller are installed on the supply line of said consumers. A group of high priority consumers is connected to a supply line via a phase switcher, allowing both forward and reverse phase switching. The extra high priority consumers are optionally connected to a guaranteed voltage unit. The microcontroller receives monitoring information about in- stantaneous current and voltage values, and also re- ceives information about the weather, the microclimate, open doors and windows, movement in the home, the status of a home microgeneration source, and air condi- tioning, heating and ventilation system parameters.

FIG. 1

EP 4 087 081 A1

## Description

### Field of the invention

The invention relates generally to electric power industry, and particularly to electrical power consumption monitoring and managing by household consumers inside the house.

### Prior art

The electric power grid has an irregular electrical power consumption pattern resulting in a power shortage during peak hours. To align the daily load schedule, various means are used including a stepwise meter rate per consumed unit (kWh) depending on the connected maximum power limit $P_{max}$ and daily electricity consumption period.

The purpose of managing electrical power consumption consumers in the home taking into account the specified rate policy is to ensure the reliability and maximum allowable power consumption by household consumers at the assigned power limit $P_{max}$, prevent their premature shutdown due to tripping of the input protective devices and save resources for power consumption in the home. To this end, various methods for monitoring of the power consumption parameters and automated power consumption management are currently used including using microcontrollers providing operations as disconnection, load shedding, limiting and distributing by power sources, grid phases, time of day, load balancing by grid phases (phase balancing). In addition, renewable energy sources, uninterruptible power supplies and energy storage units are used. At the same time, surplus electric power from renewable energy sources produced by home microgeneration in many countries may be returned to the power grid.

The object and technical result of the claimed solution is the possibility to increase the power consumption with a limited maximum current, reduce the peak and high rate components of electrical power consumption, reduce the cost of electrical power consumption (purchased electrical power), providing uninterrupted power supply to priority consumers while limiting lower priority consumers in the home and efficient use of renewable home microgeneration, which is possible due to composing of an hourly schedule of home generation based on the online weather forecast and the calculation of flexible consumption schedules for low priority and medium priority consumers with the total power (according to these schedules) as close as possible to the microgeneration power schedule.

The technical solution known in the art is implemented in the OhmPilot of the Austrian company Fronius AG, which tracks the current balance between home consumption and microgeneration and when there is an excess of microgeneration power, it is sent to a resistive load (generally, to a hot water boiler) through the Ohm-Pilot device, which is a PWM (pulse width modulator) that controls the boiler consumption from 0 to 100% of its rated power. The claimed herein method for controlling low and medium priority loads is much more flexible than the mentioned OhmPilot product, which allows to control consumption both in case of excess power produced by microgeneration by connecting multiple loads (including through a modulator through inputs AUX1, AUX2, AUX3 for alternative power supply of low priority loads) and in case of insufficient power output by disconnecting such loads. Accurate prediction of consumption is impossible due to the presence of higher priority loads, which the user can switch on at his own discretion, however one can adjust to the current consumption schedule knowing the statistics of higher priority loads.

The methods and systems are known in the prior art for monitoring and managing electrical power consumption by household consumers in the home, which are close to the claimed technical solution as described below.

The method and system are known for managing power supply and electrical load according to US patent No. 20100312414, 09/12/2010, IPC G01 R11/00, acc. ind. US N 700/295. This solution comprises intellectual automated load dumping using logical controllers reacting to signals from disturbance sensors. An intelligent system implementing this method is connected with a system of real-time signal sensors, which it uses to recognize disturbances and trigger switching-off consumers. This system is adapted to solve the problem by anticipating the recognition of repeated disturbances. This is achieved through self-learning on load dumping, dumping schedules available in the system memory.

At the same time, a method of data flow control and load dumping is proposed depending on the amount of system power reserve varying in the range from 0 to the unit rating value of system generator. In this regard, this method of managing electrical power consumption has a limited application scope. It is not suitable for systems with centralized power supply while it is effective for use in off-grid power systems (for a floating platform, etc.).

The method and device are known for uninterruptible power supply of consumers according to the patent RU No. 2341859, IPC H02J 3/32, publ. 20/12/2008, Bul. No. 35. In this solution, consumers are connected by switching means to a centralized grid, alternative energy source and energy storage unit by means of an inverter while switching is monitored and controlled by the controller.

This method comprises current type conversion, first alternating current into direct current, then direct current into alternating current. The need for double current type conversion causes additional electrical losses, complexity and rise in the implementation cost, ultimately to a decrease in economic efficiency.

The method and device for monitoring and managing electrical power consumption process are known according to the patent RU No. 2473916, IPC G01R 11/00 published on 27/01/2013, Bul. No. 3. In this method, the commands to connect consumers are transmitted through load switching devices controlled by signals from energy meters with an assigned indicator arranged into groups that measure the power consumed by the receiver (load). The information from these groups is transferred using wired communication channels to meter group controllers. The resistance and length values of the power grid feed lines from the transformer substation are recorded in the non-volatile memory unit in order to calculate the difference between the supplied and consumed energy.

The disadvantage of this method is the high cost and significant complexity of the individual data collection and transmission calculations and control.

A device where the electrical load is uniformly distributed over the power grid phases is known according to the patent RU No. 2200364, IPC H02J 1/10, publ. 10/03/2003, Bul. No. 7. It contains phase current sensors, variety of switching means and processor to control phase switching based on pairwise comparison of phase currents.

The disadvantage of this device is that it does not provide electrical power management of consumers, taking into account priority of consumer groups. For this reason, its power supply of priority consumers is not reliable enough.

The method is known for supplying the loads of the power supply system according to the patent RU No. 2442263, publ. 10/02/2012 in Bul. No. 4, which consists in deriving separately the reactive and active power components of the balanced phase groups for power supply of consumers. The disadvantage of this method is its limited use for power supply of direct current loads.

The method, system and device for managing electrical power consumed by household appliances installed in the home are known according to the patent RU No. 2242832, publ. 20/12/2004 in Bul. 235 by Aisa Valerio. This patent is taken as a prototype. The method comprises connecting consumers to a grid connected to an electrical power source, setting the maximum permissible power consumption, providing consumers with power management means, measuring the instantaneous total power consumption, transmitting information on the consumed electric power with a time-varying periodicity to the consumer control means, providing load control capability for control means.

The electrical power management system according to this patent contains multiple electrical consumers connected to a data transmission network, metering device located outside the specified electrical consumers connected to the said network and suitable for metering the instantaneous total power consumption by the system of household electrical appliances while each consumer is equipped with a consumed power control means using information on the instantaneous power consumption by the appliance system so that the closer the instantaneous total power consumption to the maximum permissible level the higher the information output periodicity.

The shortcoming of the method taken as a prototype is a lack of electrical consumer grouping based on the identical requirements for power supply reliability and possible functions of switching means on the feed lines of these groups of consumers with the establishment of power consumption priorities for the said groups of consumers. This does not allow to effectively manage the power consumption of consumers, restriction of individual groups of consumers, distribution of other groups of consumers by power sources, power grid phases and power supply time.

## DETAILED DESCRIPTION of the invention

The household electrical consumers differ in the requirements for the power supply reliability and the switching means for connection to the power grid, some of them allow load control, power-down modes, short interruption of power supply, some consumers do not even allow the voltage sine wave breaking. This invention divides all household consumers depending on the power supply reliability requirements and the switching means capabilities on feed lines into 4 groups: extra high priority; high priority; medium priority; low priority.

A group of extra high priority consumers includes consumers that do not allow supply voltage sine wave breaking. These consumers, first of all, include IT servers, TV, computer equipment, routers, servers, communications and alarm. These consumers usually do not resume operation from the state preceding the power failure even after a short interruption of power supply. They do not allow temporary disconnection at the time of peak load, switching to another phase or to a backup source or home microgeneration source. The proposed system monitors power consumption and use this information for further forecasting.

A group of extra high priority consumers also includes household electrical appliances that do not allow supply voltage sine wave breaking, i.e. that do not allow switching to a backup power supply using switching means. An example of such consumers are all devices with digital control: microwave ovens, multi-cookers, cooking top, washing machine, dryer, etc., that is, all consumers that are not able to resume operation after a short interruption of power supply.

A group of high priority consumers includes electrical appliances that allow switching the power supply to an alternate phase or renewable energy source. Such appliances in the kitchen are toasters and coffee machines.

A group of medium priority consumers includes consumers that allow power switching and short-term disconnection, that is, a short-term operation deferral. These consumers include vacuum cleaners, irons, and hair dryers in bathrooms. In the kitchen, they are a secondary power input for the cooking top of a stove (designed to distribute the load between two or more phases but not supplying power to the control electronics of this electrical appliance), oven (if equipped with an electromechanical control), microwave with an electromechanical control, and electric kettles. In terms of circuit design, they are powered through 2 series-connected relays (one switching to an alternative phase, and the second tripping). The switching of medium priority loads in the equipment is implemented by series connection of two contacts of different relays designed for switching high priority (switching) and low priority (temporary disconnecting) loads, wherein a series connection of two relays is implemented by jumpers on adjacent control channels, one high priority and one low priority. This implementation allows the flexible use of switching resources in the equipment, e.g. if the board provides 12 relays, 6 for low priority loads (disconnecting) and 6 for high priority loads (phase switching), then 2 channels of medium priority loads may be provided by rearranging the jumpers with remaining available 4 high priority channels and 4 low priority channels, i.e. implementation of 12 relay board enables configurations of 6+0+6, 5+1+5, 4+2+4, 3+3+3 (high priority, medium priority and low priority load connection channels).

These consumers are of high priority, however, they allow short-term disconnection. Therefore, during the peak period, the control algorithm primarily determines (based on the available power) the possibility of continuing their operation by switching to another phase in order to avoid phase overload if there is an available power in the alternative phase for a given consumer. If there is no available power in the alternative phase, then this consumer will be temporarily switched off until the available power appears either in the consumer default phase or alternative phase. Thus, medium priority loads are temporary disconnected only if there is no available power. In this case, the operating cycle of such devices can be predicted in order to ensure the required power consumption by selecting the duty cycle.

A group of low priority consumers includes consumers that allow temporary shutdown, e.g. in peak modes during overload, at high hourly rates per kWh. This group includes pool pumps, waterfall pumps, floor heaters, hot water heaters, dishwasher (all modern dishwashers have a non-volatile memory and resume operation from the state preceding the power failure). A special place is occupied by loads responsible for heating and air conditioning (air conditioners, heat pumps and electric underfloor heating). Heating systems have high thermal inertia, therefore, it is not very important for them at what time periods they consume electrical energy, it is important that they are supplied while maintaining a certain duty cycle, e.g. within 40 to 60%, then the heating systems will provide the necessary comfort due to the production of the required thermal energy while maintaining the required duty cycle for time intervals comparable to the thermal inertia time constant of the room but they will not consume the available power during the peak periods.

The situation is more complicated with cooling (air conditioning) systems in summer. If such a system is chiller-based, then generally an inertial tank is provided preventing frequent starting/stopping of the chiller compressors (in order to reduce wear) and this inertia may be used to temporarily turn off the chiller compressor (which is the largest consumer in home) in order to effectively deal with consumption peaks. It is only a matter of adapting the permissible disconnection time to the implemented inertia of the cooling circuit in order to maintain comfort.

**Summary of the invention as a method**

A method for monitoring and managing the monitoring and managing electrical power consumption by household consumers in the home comprises connecting household consumers to the power grid using switching means, setting a maximum power consumption limit ($P_{max}$), equipping consumers with power management means, measuring the instantaneous total power (current) consumption, setting priorities for electrical consumers in terms of reliability and switching method on connection lines, transmitting monitoring information to a microcontroller, power management of household consumers connected to an external grid and home power supply sources.

A group of extra high priority consumers that does not allow the voltage sine wave breaking is optionally connected to a guaranteed voltage unit adapted to receive power from a centralized, backup and storage electrical power sources.

A group of high priority consumers that allow short-term disconnections during switching is uniformly distributed between the power grid phases and connected to the grid via switching means allowing switching to backup source and both forward and reverse phase switching.

A group of medium priority consumers is uniformly distributed between the power grid phases and connected to the grid via switching means allowing deferral of the consumer operation according to a timer.

A group of low priority consumers is uniformly distributed between the power grid phases and connected to the grid via switching means ensuring their proactive disconnection before the peak periods.

In order to control power consumption, instantaneous voltage and consumed current values are monitored in the phases of feeder and supply lines of consumer groups with regular transmitting the said monitoring information to the microcontroller. An electronic interface unit is installed for connecting to the Internet and accessing monitoring information adapted to remotely turn on/off/control heating, air conditioning and hot water supply systems. An automated forecasting of power consumption for heating is carried out based on remote measurement of temperature and humidity in rooms, detection of open windows and doors, monitoring of microclimate parameters and air conditioning system control. The human absence in the rooms is determined to close the detected open doors and windows and stop the air conditioning and hot water supply systems. Automated control of consumer power consumption is carried out based on the results of forecasting consumer loads. The statistical monitoring information for the previous time of consumer power management in the home is collected and processed. An electronic database is created for consumed power/current, outdoor climate parameters and microclimate parameters inside the home with reference to annual and daily power consumption schedules, the simultaneous operation of different priority groups of consumers is determined. The loads of hot water recirculation and cold water supply system are controlled.

With a shortage of power reserve during peak hours and high rates per energy unit, the consumers are switched to a backup power source with a battery if any.

If a home microgeneration source is available, the power generated by it is consumed primarily through the compilation of flexible set schedules in order to minimize the power purchase from the utility company.

A group of extra high priority consumers is optionally connected to a storage power source, preferably to an inverter with a battery.

A group of high priority consumers is connected to the power grid via switching means allowing switching to less loaded phases of the grid, mainly by changing the phases one step forward/backward.

A group of low priority consumers is connected to the power grid via switching means ensuring their disconnection during periods of high hourly power rates and consumption peaks.

To prevent phase load imbalance, the current values in the neutral wire are monitored. In addition, the harmonic distortion of the voltage sine wave shape is controlled in the phase wires.

When a power reserve in the grid is below the established minimum, preferably equal to the unit load of the largest priority electrical consumer, the periodicity of transmission of monitoring information about instantaneous current and voltage values to the microcontroller is multiplied (10-20 times).

## Summary of the invention as a system

The system for monitoring and managing electrical power consumption by household consumers includes the electric power grid in a home connected to an external power source, electrical consumers connected to the said grid, means for measuring the power consumed by consumers, and means for controlling the load. The system, wherein a group of extra high priority consumers is connected to the guaranteed voltage node, a group of high priority consumers is connected to the grid via power relays allowing switching the grid phases. Medium priority consumers are connected to the grid using power relays allowing disconnecting from the grid to defer their operation according to a flexible set schedule and/or switch the grid phases. Low priority consumers are connected to the grid via power relays, which are automatically tripped by a microcontroller signal of peak loads in the grid or a change in the hourly power rate, multiphase switching means for consumers and consumers are connected to a microcontroller that controls the loads and load phase distribution and time shift. The microcontroller is equipped with an analog-to-digital converter (ADC) and connected to sensors for measuring voltages and currents in the phase wires of consumers and phases of feeders including external current sensors connected via connectors and located on the phase wires of the feeder and loads and internal current sensors as part of the circuit boards of current relays as well as dividers (optionally, on the neutral ground wire) to measure the voltage to ground including on the lines of an alternative home microgeneration power source. The system is equipped with an electronic interface for external access via the Internet to monitoring information and remote control/turn on/off loads of heating, air conditioning and hot water supply systems. It comprises external auxiliary devices with wireless sensors that detect open doors and windows in order to eliminate heat losses and improve power consumption taking into account the human presence in the rooms and predict changes in electrical heating loads.

The system comprises a guaranteed voltage node connected to a centralized as well as backup power sources.

High priority consumers are connected to the grid by means of power relays for switching to an alternate phase.

The system comprises a microcontroller that has analog inputs to obtain measured voltage and current values, equipped with an ADC of sufficient throughput and capacity (0.1-1.0 Mcounts/s; 10-12 bits), has a hardware interface for Internet communication and smart sensor (WiFi / Bluetooth LowEnergy) and home automation networks (smart home), e.g. KNX/EIB (European Installation Bus) to receive smart home messages, in addition, it comprises non-invasive inductive current sensors for external measurements and linear Hall current sensors for measuring currents on the relay board.

The system comprises a controller made integral with a relay board in the form of a two-level assembly, where a relay board with Hall sensors and inductive sensor level converters is located in the lower part of a dielectric (plastic) housing adapted to mounting on a DIN rail, the controller board is located in the upper part, wherein a power feeder (three phase conductors and neutral) is inserted into the relay board so that feed lines pass through the board, from which the feed lines of low priority consumers are outgoing through the normally closed contacts of the relay, and the lines of high priority consumers are grouped two per phase allowing switching one of the lines to the next phase, and the other one to the previous phase.

In addition, individual priorities are assigned to medium and high priority group consumers allowing to set their disconnection sequence during power management.

Using power limiters (power relays), a hierarchical power supply scheme was designed where relays installed in series or in parallel feed lines of consumer groups are configured individually, each to separate power consumption (current) limit depending on the priority of the group of consumers fed. When the threshold power level is exceeded, the lower priority groups of consumers will be sequentially automatically disconnected. Automatic connection of consumers is carried out when a power reserve appears in the corresponding home distribution network, wherein higher priority consumers are connected first.

In modern homes, consumers are distributed in a significant area and an Internet-based interface is used to collect information about the instantaneous current and voltage parameters from consumers.

In managing the power consumption of receivers, the following methods and means are used to limit and reduce load peaks: turning off the consumer using a switching means on the line connected to the power grid to switch it to other grid phases or another source; means for controlling the electrical load level installed directly on the consumers (auxiliary load control means); deferring the operating periods of consumers to another time using switching means on the lines connected to the power grid. The switching means are controlled by a microcontroller by disconnecting and switching consumers based on the analysis of results of processing the instantaneous current and voltage parameters both at the input feeder and along the lines of groups of consumers and individual consumers received periodically from sensors (forming sequences of restrictions).

In addition, the microcontroller receives periodically information from sensors via communication lines: about the microclimate parameters in the rooms (air temperature, humidity), state of doors and windows (open/closed), human presence in the home, outside air temperature. The monitoring information from the sensors is analyzed by the microcontroller, the lists are generated for controlling the power consumption modes of individual consumers, disconnecting consumers, deferring operation to another time, switching phases, etc.

The load in a home three-phase electrical distribution network is distributed between three phases. In peak modes of power consumption, the load is reduced and individual receivers are disconnected, wherein the phase load imbalance is monitored and the phases are balanced by loads. At the same time, uninterruptible power supply for high priority consumers is provided. When managing the power consumption of consumers in the home, it is ensured that the maximum input power consumption limit is not exceeded subject to maximum possible power consumption, quality and efficiency compliance and power consumption priority of consumer groups and individual consumers in groups.

Algorithms of response to the monitored information from sensors in the method for managing the power consumption of consumers depend on what power reserve is available for loading the consumers.

The loads in the base part are distributed and balanced between phases of the distribution network by switching consumers to other phases, disconnecting low priority consumers.

During peak periods, when the power (current) reserve decreases below the permissible value, the household consumers are switched to low-power modes, low priority loads are disconnected, consumers are switched to other phases (forward or reverse phase switching), connected to a backup (alternative) home microgeneration source, connected to a storage energy source and guaranteed voltage node.

## DESCRIPTION OF DRAWINGS

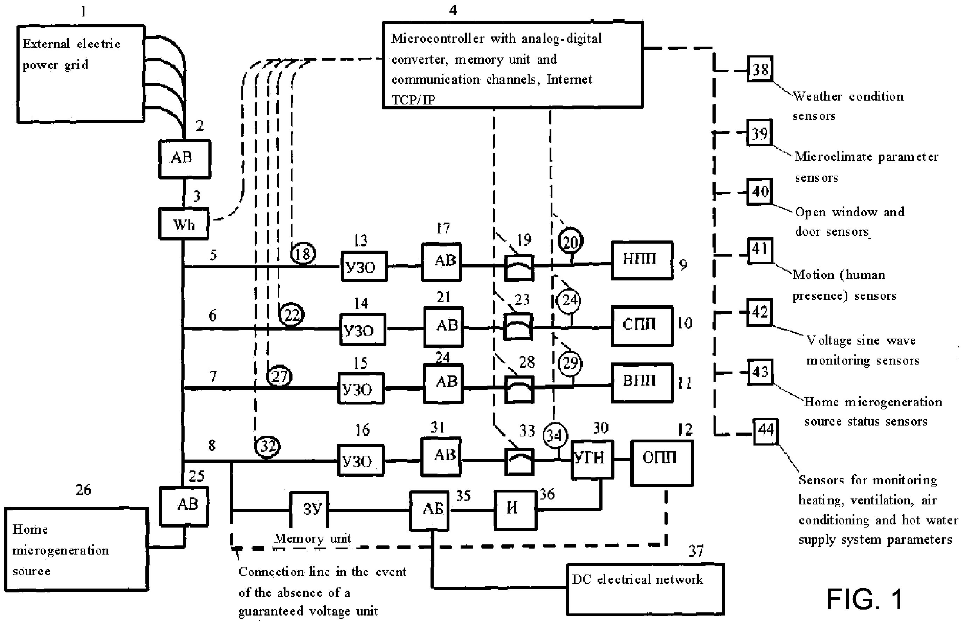

Fig. 1 shows a system implementing a method for monitoring and managing the electrical power consumption by consumers in the home. Three phase wires and neutral from the centralized external source 1 are inserted into the home via the circuit breaker 2 and counter 3 installed on the entrance board of the home. A microcontroller 4 is installed to control power consumption. The three-phase electrical distribution network is made in the form of separate lines 5, 6, 7 and 8 for low priority, medium priority, high priority and extra high priority groups of consumers 9, 10, 11 and 12, respectively. Protective shutoff devices (PSD) 13, 14, 15 and 16 are installed on each line.

A group of low priority consumers 9 is connected to line 5 via a circuit breaker 17. Sensors 18, 19 and 20 are installed on line 5 for measuring and transmitting instantaneous current and voltage values using wired and wireless means to microcontroller 4.

Medium priority consumers 10 are connected to line 6 via an automatic switch 21 allowing switching phases and disconnecting with operation deferral to another time on demand, e.g. using a timer. Sensors 22, 23, 24 are installed on line 6 for measuring and transmitting instantaneous current and voltage values using wired and wireless means to microcontroller 4.

The group of high priority consumers 11 is connected to line 7 via a phase switcher 24 allowing both forward and reverse phase switching. Lines 5, 6, 7 and 8 can also be connected via a switch 25 to an alternative home microgeneration source 26. Sensors 27, 28, 29 are installed on line 7 for measuring and transmitting instantaneous current and voltage values using wired and wireless means to microcontroller 4.

Extra high priority consumers (EHPC) 12 are optionally connected to the guaranteed voltage unit (GVU) 30. In turn, GVU 30 is connected via a circuit breaker 31 to line 8, where the sensors 32, 33, 34 are installed for measuring and transmitting instantaneous current and voltage values using wired and wireless means to microcontroller 4. GVU 30 is connected to a storage battery 35 via an inverter 36. The storage battery is connected to line 8 via a charger. If the GVU is not installed in the home, the storage source is connected directly to line 8 where current sensors 33 and voltage sensors 34 are installed.

The microcontroller 4 is connected to the sensors via radio and the Internet to obtain monitoring information about the instantaneous current and voltage values: in the feeder phases from the electric meter 3, in the distribution lines from external sensors 18, 22, 27, 32, in the feed lines of groups of consumers from current sensors 19, 23, 28, 33 and voltage sensors 20, 24, 29, 34.

Microcontroller 4 is equipped with an analog-to-digital converter (ADC) for converting analog signals into digital information. The microcontroller modules receive information from sensors 38, 39, 40, 41, 42, 43, 44 that monitor weather, microclimate, open doors and windows, movement in the home, quality of voltage sine wave, status of a home microgeneration source, and air conditioning, heating, ventilation and make-up of the hot water supply system parameters.

To receive/transmit monitoring information to the microcontroller an electronic interface unit is installed for connecting to the Internet and accessing monitoring information adapted to remotely turn on/off heating, air conditioning and hot water supply systems, automated forecasting of heat load based on remote monitoring of temperature and humidity in rooms, detection of open windows and doors, monitoring of microclimate parameters and air conditioning system control, human presence in the rooms is determined to stop the air conditioning system, automated control of consumer power consumption is carried out based on the results of forecasting consumer loads, the statistical monitoring information for the previous time of consumer power management in the home is collected and processed, an electronic database is created for consumed power/current, outdoor climate parameters and microclimate parameters inside the home with reference to annual and daily power consumption schedules, the simultaneous operation of different priority groups of consumers is determined.

The home microgeneration uses alternative renewable energy sources, preferably solar panels and wind-powered generators, the possible power output of which depends on the time of day and weather conditions. So, the power curve of the solar panels depends mainly on the season, time of day and the presence of clouds. If wind-powered generators are used as a home microgeneration source, their available power output depends on the wind availability and speed. In this regard, the microcontroller forecasts in advance the schedule of changes in the available power output of a home generation source. The indicated advance forecast of available power is performed by a microcontroller based on Internet-based weather forecasts and parameters (characteristics) of the statuses of home microgeneration sources taking into account the daily trends.

When using power, a cheap renewable energy from the home microgeneration source 26 is consumed on a priority basis. Automatic control of the consumer loading/supply sequence is carried out as follows: first, the high priority consumers 11 are supplied, then, subject to the power availability, the medium priority consumers 10 are supplied and, lastly, the low priority consumers 9. When controlling the consumer disconnection, the reverse operation sequence is used: first, low priority consumers 9 are disconnected, then, provided that the available power is insufficient, medium priority consumers 10 are disconnected and, lastly, high priority consumers 11.

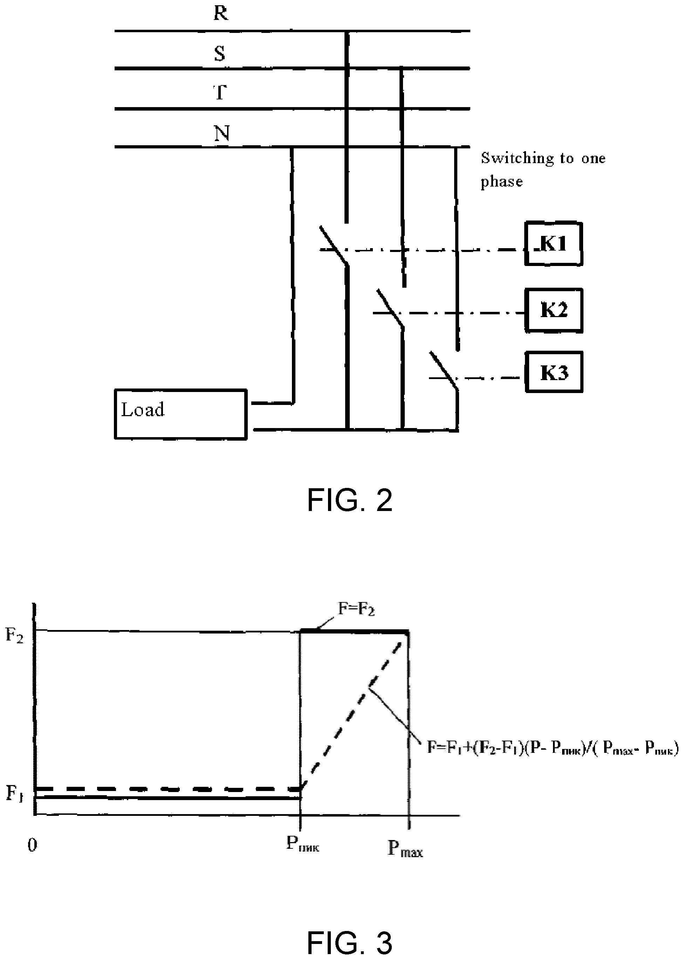

Fig. 2 shows a diagram of single-phase high priority load switching to one of the phases of a three-phase four-wire power grid. The device works as follows. The microcontroller automatically selects the phase closest in priority within the user-defined settings and connects a single-phase load thereto.

Wherein one of the power relays K1, K2, K3 connects the load to the less loaded phase according to the microcontroller signal.

Fig. 3 shows a curve of the transmission frequency change for monitoring information about instantaneous current parameters versus total consumer load in the home. In the peak load region, the frequency of information transmission is an order of magnitude greater. Two possible curves of information transmission frequency change in the peak mode are presented, stepped (solid line) and inclined (dashed line). The power consumption at the start of the peak mode is $P_{peak}$. The maximum power reserve in peak mode ($P_{max}$ - $P_{peak}$) is taken equal to the unit load of the largest priority consumer $P_1$, i.e. ($P_{max}$ - $P_{peak}$) = Pi

Basic loading interval: at loads from 0 to $P_{peak}$; peak loading interval: with total power consumption above $P_{peak}$.

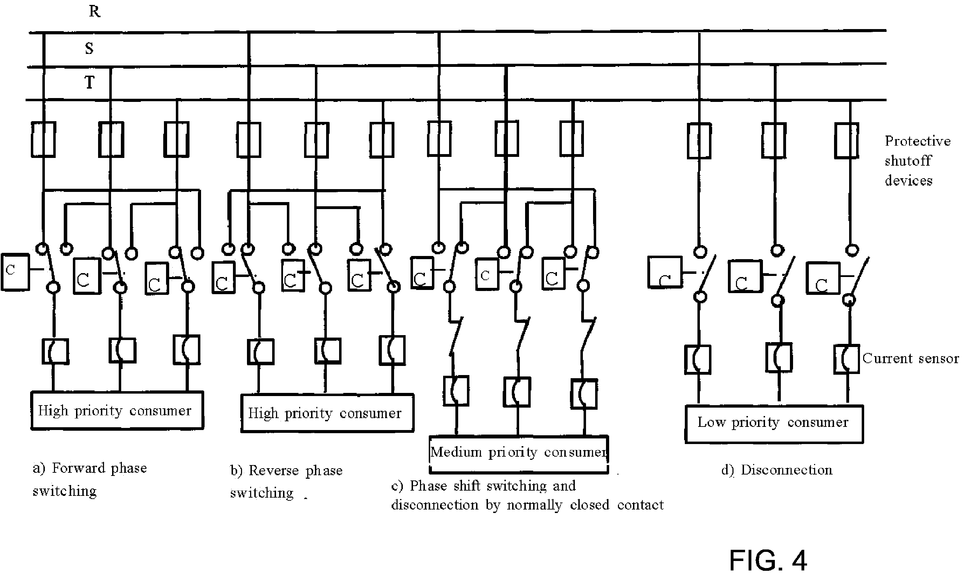

Fig. 4 shows a diagram of switching and disconnection of consumers connected to a three-phase home power grid. For groups of high priority consumers, two diagrams are provided: diagram (a) for forward phase switching (to the next phases) and diagram (b) for reverse phase switching (to previous phases). Medium priority consumers are connected according to the diagram (c) where they are disconnected and reconnected according to a flexible set schedule (for example, according to a timer), that is, their operation is deferred to another time. Low priority consumers on the connection line are equipped with a power relay with normally closed contacts: diagram (d).

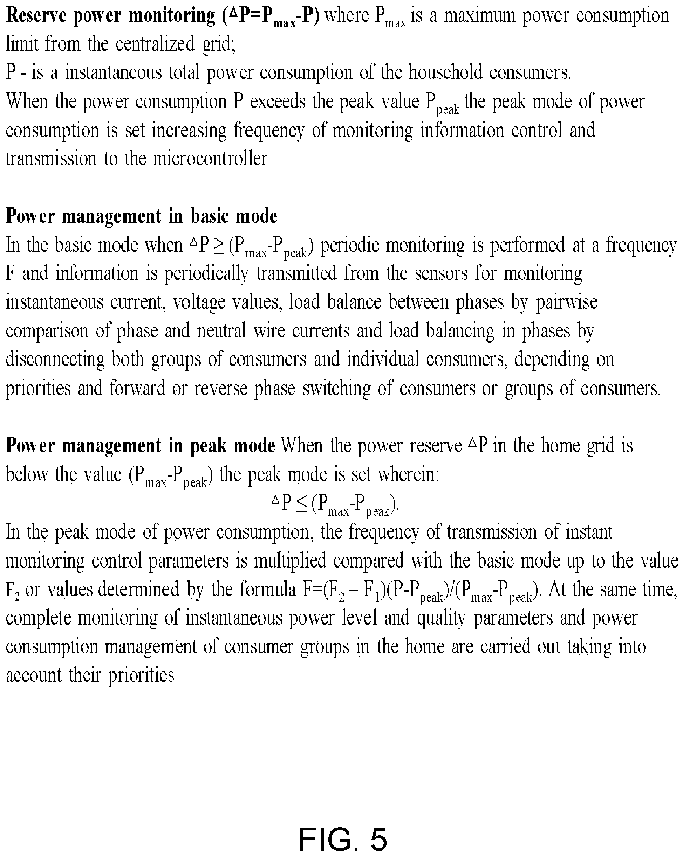

Fig. 5 shows an operation sequence for monitoring and managing electrical power consumption in the basic and peak operating modes of household consumers. The power reserve in peak modes is within 0 to (Pmax - Ppeak). In the basic mode, the frequency of information transmission from sensors about instantaneous values of power consumed by consumers is kept constant and equal to F0, approximately taken equal to 1 s 1. In the PEAK mode, where (Pmax - P) < (Pmax - Ppeak), the transmission frequency of controlled parameters is increased stepwise (by 10-20 times) or in proportion to the increase in load over Ppeak calculating it by the formula:

$$F = F0 + k\, F0\, (P - Ppeak) / (Pmax - Ppeak),\ 1/s,$$

where k is a reacting factor.

The k value depends on the peak load curve slope, k = 10-20.

Maximum power reserve in peak mode (Pmax - Ppeak) is taken equal to the unit load of the largest priority consumer, i.e. (Pmax - Ppeak) = Pi.

The power reserve value in peak mode (Pmax - Ppeak) depends on the number and power of household consumers and lies approximately in the range of 0.1 Pmax to 0.25 Pmax.

The change in monitoring information transmission frequency during the basic to peak mode transition can be considered stepwise: F0 in the basic loading region, (10-20) F0 in the peak mode.

When a power consumption reserve DR = (Pmax - P) is above its minimum value (Pmax - Rpeak) the control is carried out in the basic mode of home power grid, i.e.

$$DR > (Pmax - Ppeak),$$

information is periodically transmitted from the sensors for monitoring instantaneous current, voltage values, load balance between phases by pairwise comparison of phase and neutral wire currents and load balancing in phases by disconnecting consumers and forward or reverse phase switching of consumer groups.

When the power reserve in the grid (Pmax - P) is lower than (Pmax - Ppeak) the home consumers are in the peak mode. In the peak mode, a complete monitoring of instantaneous parameters and power consumption of consumer groups in the home is carried out taking into account their priorities. In this mode, the monitoring information transmission frequency increases and the controller generates solutions to limit power consumption and switch consumers to other less loaded phases and an alternative renewable home microgeneration source.

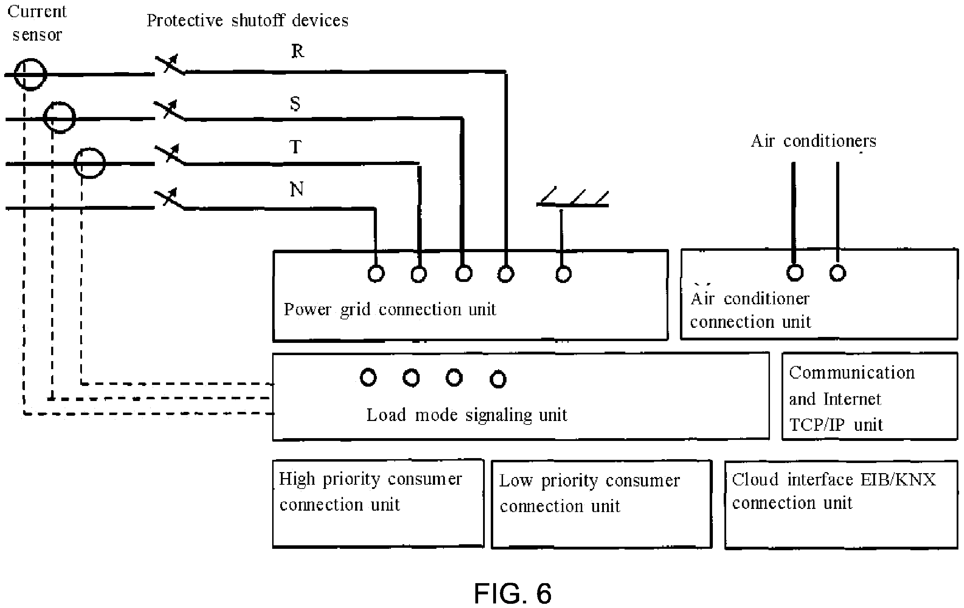

Fig. 6 shows the microcontroller functional elements. The microcontroller comprises 7 units: network connection; air conditioner connection; load mode signaling; communication and Internet (TCP/IP); high priority consumer connection; low priority consumer connection; home automation interface (EIB/KNX) connection. The load mode signaling unit has a light signaling panel with color LEDs indicating the load status of the home power grid. Load modes: blue, no load; green, low load; yellow, high load; red, peak load.

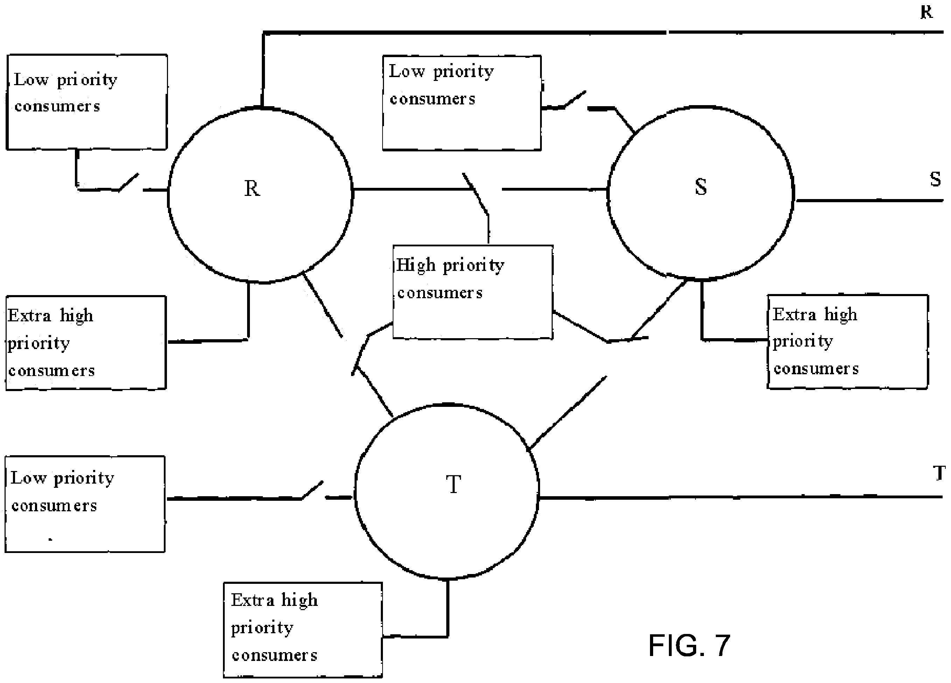

Fig. 7 shows a switching means for single-phase low priority and high priority consumers adapted to make load control circuits. The means comprises three separate phase circuits R, S, T. It is made for each consumer in the form of a series connection of contacts of two independent power relays, one of which is destined to control a low priority load by opening a normally closed contact, and the other relay is destined to control a high priority load by switching the power supply of the load between two phases, wherein the relay to be used is selected by jumpers providing either the independent operation of each of two relays or a series connection of their contacts for the consumer switching.

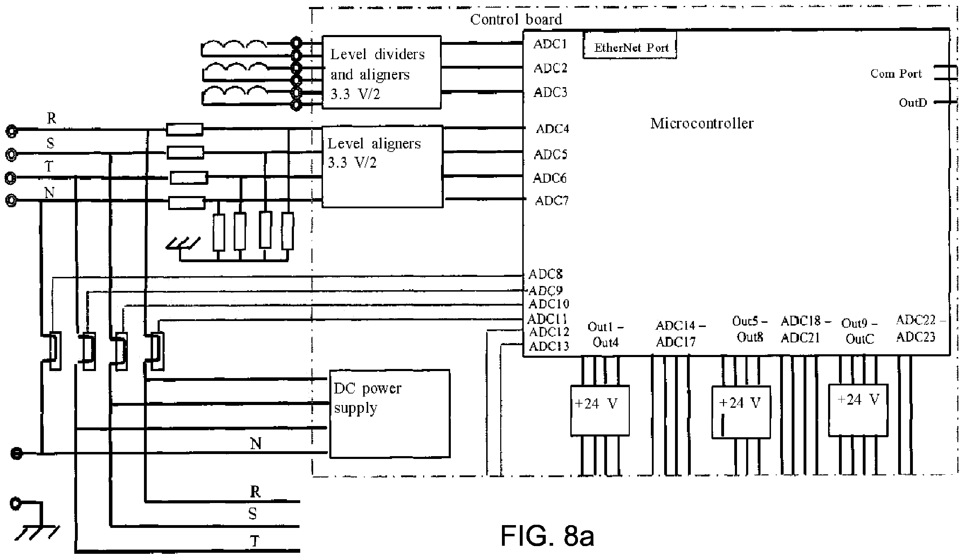

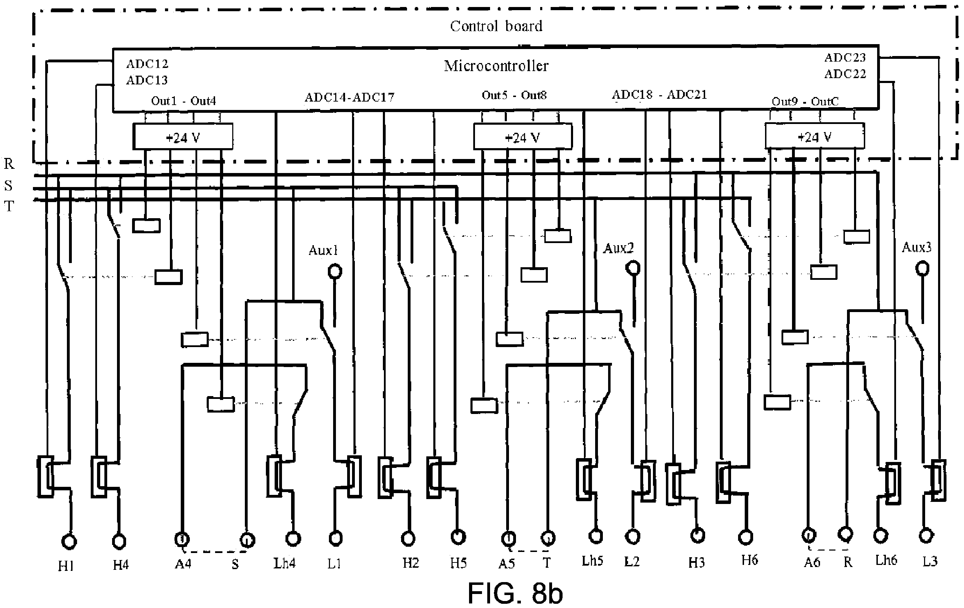

Fig. 8 is represented by two halves of the diagram: Fig. 8a and Fig. 8b. Fig. 8a shows a connection diagram of the microcontroller to a three-phase four-wire power grid and power and operational circuits of electrical loads. The microcontroller board (Fig. 8a) has the measurement circuits, contacts ADC1, ADC2, ... ADC22,

ADC23, power relay control networks Oi+1, ... Oi+4, Oi+5, ... Oi+8, Oi+9,

..., Oi+C, Com Port, OutD, Ethernet Port.

Dividers and level adapters of 3.3 V/2 phase and neutral wires are connected to contacts ADC 1, ..., ADC7. Lines from current sensors on phase wires and consumer lines are connected to contacts ADC8, ..., ADC23. The control lines of the power relays are connected to the contacts Outl, ..., OutC.

Fig. 8b shows a connection diagram of the microcontroller contacts with the current sensors and power relay coils. It shows the power relay contacts used for consumer connection to the phase wires R, S, T. Terminals H1, ..., H6 are destined to connect high priority consumers. Terminals L1, ..., L3 are for connecting low priority consumers. Terminals Lh4, Lh5, Lh6 are for connecting low or medium priority consumers. Terminals A4, A5, A6 are auxiliary for medium priority consumers. The dashed lines show jumpers between terminals A4 and S, A5 and T, A6 and R.

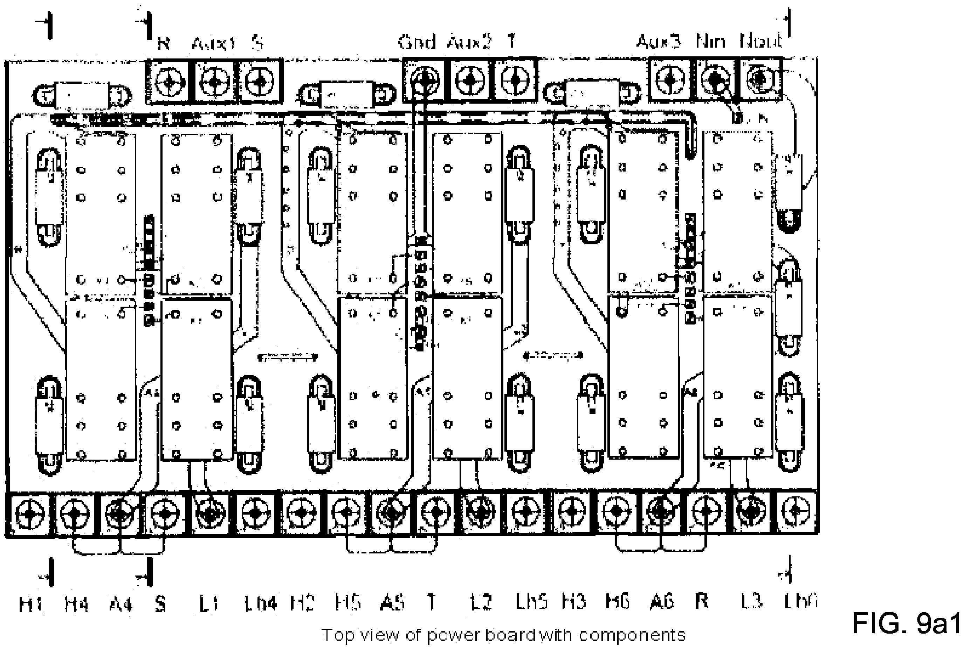

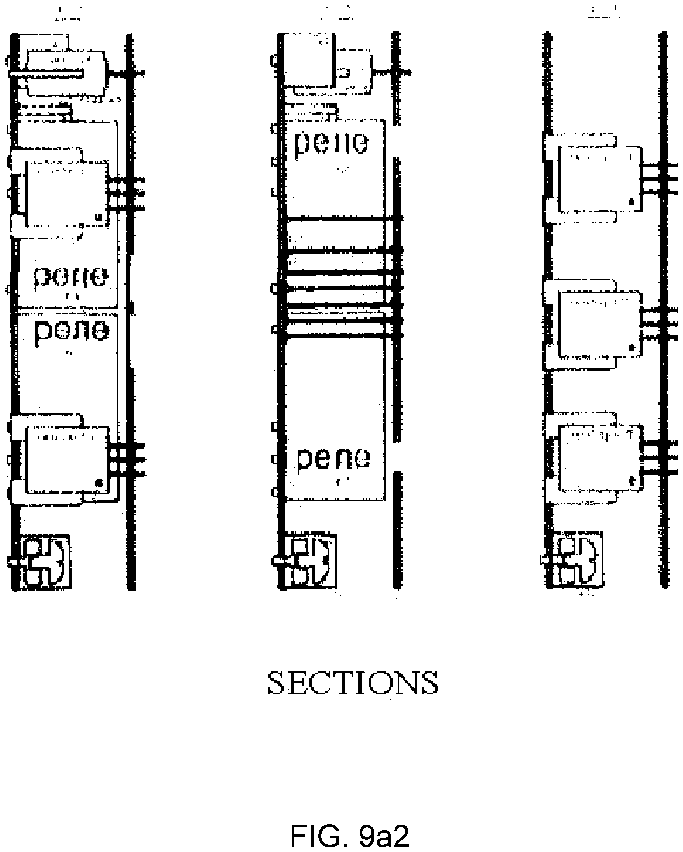

Fig. 9a shows a plan (top) view and sections 1-1, 2-2, 3-3 of a two-level controller structure comprising two horizontal boards, between which the controller circuit elements shown in Fig. 8a and 8b are placed. The bottom board contains power elements: relays K1, ..., K 12; current sensors S1, ..., S16; power terminals for connecting consumers installed in one row (at bottom of the plan). Terminals for connecting the phase wires R, S, T are located on the opposite side of the power board (on top of the plan) in the same row with the terminals Aux1, Aux2, Aux3 are located (alternative source connections), terminals Nin and Nout (input and output of feeder neutral wire, respectively), terminal Gnd (ground).

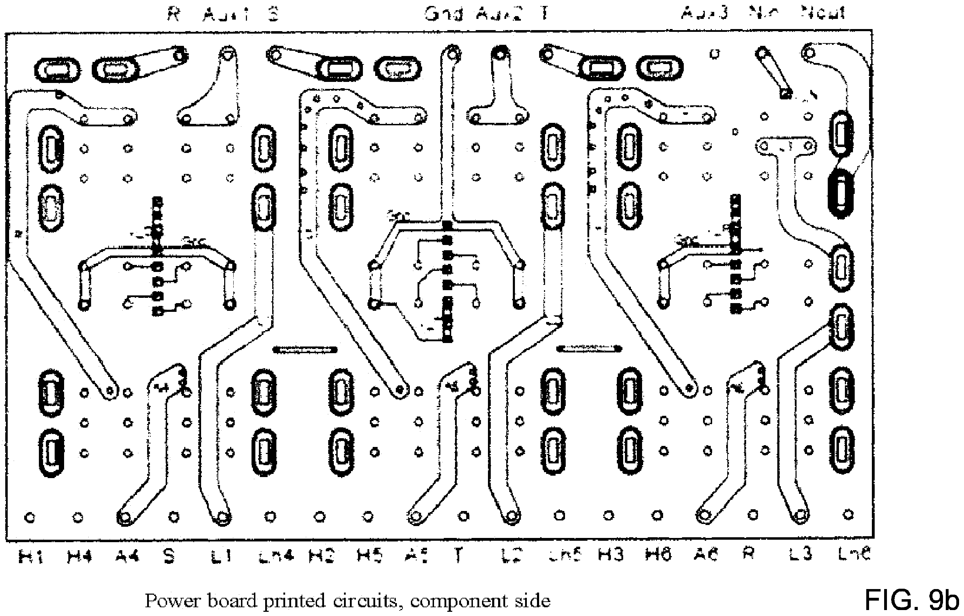

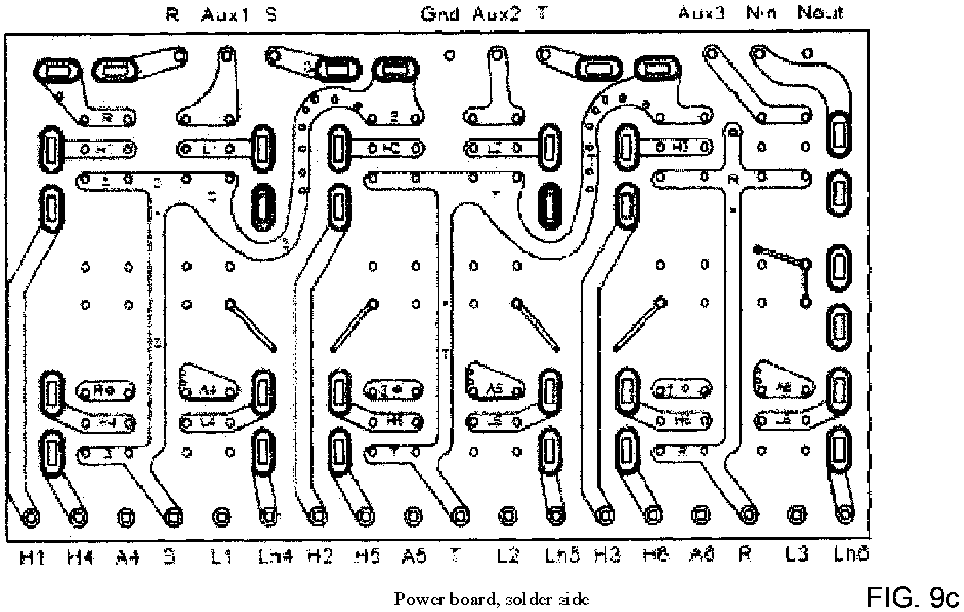

Fig. 9b and 9c (power board on the component side and solder side, respectively) show the layout of the printed circuits on the power board and connectors for current sensors.

The neutral wire input and output are connected to each other by a wire passed through the current meter (sensor), i.e. when the current is measured, the neutral wire voltage to ground is also measured. When a current of minus 50 A ... +50 A passes through the current sensors they induce a voltage of 0 ... 5 V, which is measured and digitized. If the ADC is 12 bits (4096 digitization levels), 1 step is 25 mA that is very close to the actuation threshold of the household RCD of 30 mA.

If the ADC capacity is 16 bits, then the current measurement accuracy will be 50 A/32K codes, i.e. about 1.5 mA. Considering the spread of 1 least significant bit, the measurement accuracy will be 3 mA, which is 10 times less than the actuation threshold of a standard RCD for household circuit protection.

This resulting that it is possible to implement "smart" RCD which will be able to distinguish false alarms caused by high-frequency grid pickups, high reactive loads in one phase, etc. from true earth leakage using digital filtering implemented in our controller software.

The default sensitivity or actuation threshold is taken as standard 30 mA generally accepted for household RCDs. If needed, the response threshold can be modified depending on the application, e.g. a finer actuation threshold is required for medical devices, and a coarser actuation threshold is required for industrial installations.

The NXP controllers have the ADC resolution of 16 bits (with the same 1 MCounts per second) making this function even more accurate and allowing to detect long-term small earth leakage, e.g. from switching power supply units.

Using averaging and correlation of voltages and currents, the presence of a small leakage to the ground may be calculated by inequality to zero of the sum of currents of the phase and neutral wires at the controller input. First, the very fact of leakage is determined by measuring and summation of currents. Then, the smart RCD function, knowing the consumer distribution by phases and instantaneous values of consumption currents, calculates which consumer is leaking.

The next step in this function is to determine the possibility of disconnecting a leaking consumer. If the consumer is fed by a low or medium priority circuit, it is disconnected along with sending a message to the user.

Options for notification of a detected emergency situation: SMS text message to a mobile phone, e-mail, message via web-applications, or a sound/light signal integrated in the controller design.

Before making decision to notify a fault or disconnect a consumer, the smart RCD function monitors the leakage development and when an inevitable increase in leakage is detected or a critical value is reached (the actuation threshold or some percentage thereof: 50%, 75%), a decision is automatically made to disconnect the consumer or to notify the user. In a certain delay, after disconnection, an attempt is made to restore the power supply to the disconnected consumer. In a case normal operation restoration, the controller cancels its emergency status and sends a corresponding message to the user. Otherwise, a repeated disconnection is performed accompanying with corresponding message to the user.

The interval between repeated switching on of the faulty consumer with each subsequent switching on increases. If a chronic but small leak with a value less than the actuation threshold is noticed for a certain consumer, then the user is informed about it and the consumer is assigned the status of potentially hazardous. If a potentially hazardous consumer restores a safe mode of operation, the hazardous status is removed but the user is sent a message with warning that this consumer has ceased to show a leak but this may be due to its inclusion in a non-grounded electrical circuit and the body of this device may be under voltage.

The controller can warn that such a consumer has been switched to a non-grounded outlet resulting in the small leakage stopped, therefore, its body will be under voltage.

Since the controller software is able to identify each such consumer regardless of the monitored power circuit, in which it is connected, its potential leakage status will be monitored at regular intervals.

Therefore, the device having hardware for measuring currents and voltages with sufficient accuracy both at the feeder including the neutral wire and at connected and monitored consumers due to the built-in smart RCD function allows to distinguish false alarms from true earth leakage and if a leak is detected can determine, which consumer is leaking and if a leak is detected on a low or medium priority control channel can disconnect this particular faulty consumer.

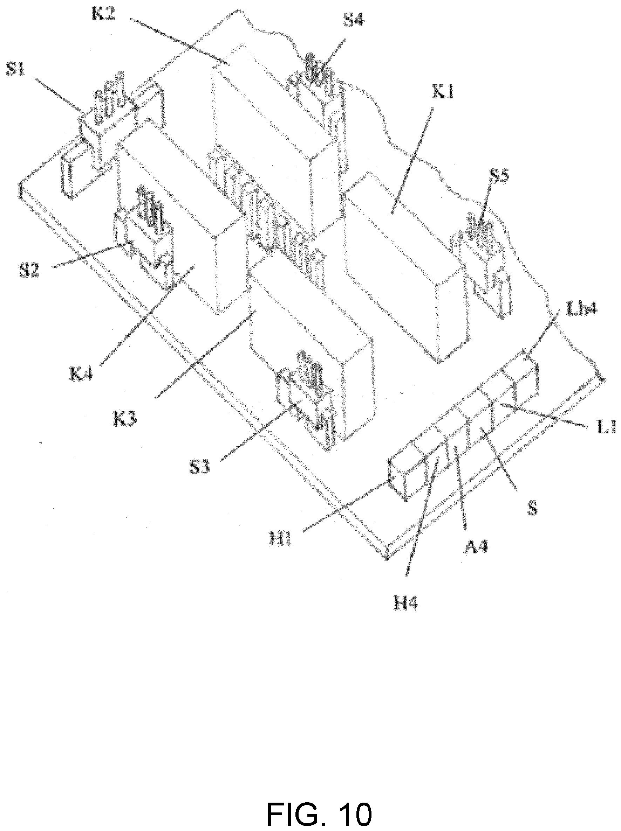

Figure 10 shows a fragment of the power board layout shown in fig. 9, with installed power relays K1, ..., K6, current sensors S1, ..., S5, power contact groups H1, H4, A4, S, L1, Lh4 and low-current contact vertical outlets from current sensors and from power relays. These outlets provide a connection with the contact grooves of the upper low-current board installed on top at a height providing guarantee of preventing potential breakdown if insects getting into the space between boards.

## Claims

1. A method for monitoring and management of the electrical power consumption by household consumers in the house comprising connecting household consumers to the power grid using communication (tools switching) means, setting a maximum power consumption limit (Pmax), equipping consumers with power management means, monitoring the instantaneous total power (current) consumption, setting priorities for electrical consumers, transmitting of monitoring information to a microcontroller, power management of consumers, WHEREIN the household consumers are divided into the consumer groups depending on the power supply reliability requirements and the switching means capabilities on feed lines establishing the priorities for the said consumer groups: extra high priority, high priority, medium priority, low priority, wherein a group of extra high priority consumers that does not allow the sine wave voltage breaking is optionally connected to a guaranteed voltage unit adapted to receive power from a centralized, backup and storage electrical power sources, a group of high priority consumers that allow sine wave voltage breaking during automatic switching to backup power source is uniformly distributed between the power grid phases and connected to the grid via switching means allowing automatic switching to backup source and both forward and reverse phase switching, a group of medium priority consumers allowing interruption of power supply during peak period are uniformly distributed between the power grid phases and connected to the grid via switching means allowing shift of their operation time (connection and disconnection) according to a flexible set schedule, a group of low priority consumers is uniformly distributed between the power grid phases and connected to the grid via switching means providing their proactive disconnection before the peak periods, providing instantaneous voltage and consumed current values monitoring in the phases of feeder and supply lines of consumer groups with regular transmitting the said monitoring information to the microcontroller, installing an electronic interface unit for connecting to the Internet and accessing monitoring information adapted to remotely turn on/off heating, air conditioning and hot water supply systems, an automated forecasting of power consumption for heating on the base of remote monitoring of temperature and humidity indoors, detection of open windows and doors, monitoring of microclimate parameters and air conditioning system control, the lack of habitability of rooms detection, automated control of consumer power consumption is carried out based on the results of forecasting consumer loads, collection and processing of statistical monitoring information for the previous time of consumer power management inside the house, creation of an electronic database for consumed power/current with instantaneous value reference (binding ) to the time of day, date and month, creation of an electronic database for outdoor climate parameters and microclimate parameters inside the house with instantaneous value reference (binding ) to the time of day, date and month, providing of different priority groups of consumers simultaneous operation including load control of hot water recirculation and replenishment of cold water supply system.

2. A method for monitoring and electrical power consumption management as recited in claim 1, wherein a renewable energy from the home microgeneration source (wind-powered generators, solar panels) is consumed on a priority basis, automatic control of the consumer loading/supply sequence is carried out as follows: firstly , the high priority consumers are supplied, then, in the case of the additional power availability, the medium priority consumers are supplied and, lastly, the low priority consumers, wherein the microcontroller forecasts beforehand the schedule of changes in the daily power output based on Internet-based weather forecasts, clouds and wind and parameters of home microgeneration sources including.

3. A method for monitoring and electrical power consumption management as recited in claim 1, wherein a group of extra high priority consumers is additionally connected to a storage power source, preferably to an inverter with a battery.

4. A method for monitoring and electrical power consumption management as recited in claim 1, wherein the renewable energy sources are used as a home microgeneration source, preferably, pumped storage power plants, wind powered generators and solar panels.

5. A method for monitoring and electrical power consumption management as recited in claim 1, wherein a group of extra high and high priority consumers is connected to the power grid via switching means providing switching to less loaded phases of the grid, mainly by changing the phases one step forward/backward.

6. A method for monitoring and electrical power consumption management as recited in claim 1, wherein a group of low priority consumers is connected to the power grid via switching means providing their disconnection during periods of consumption peaks and high hourly power rates.

7. A method for monitoring and electrical power consumption management as recited in claim 1, wherein current values in the neutral wire are monitored, digitized with a specified periodicity and capacity to test/control leakage and phase load imbalance.

8. A method for monitoring and electrical power consumption management as recited in claim 1, wherein the voltage values in the phase wires are monitored and digitized and the harmonic distortion of the voltage sine wave shape is controlled in the phase wires.

9. A method for monitoring and electrical power consumption management as recited in claim 1, wherein on decrease of the power reserve in the house grid (Pmax - P) below the predefined minimum, preferably equal to the unit load of the largest priority electrical consumer Pi the frequency of transmission of monitoring information about instantaneous current and voltage values to the microcontroller is increased by an amount proportional to the relative increase in load after switching to peak mode, i.e. in proportion to the RATIO of (P - Ppeak)/(Pmax - Ppeak).

10. A method for monitoring and electrical power consumption management as recited in claim 1, wherein a self-learning software is installed and connected to a house consumption automation network ("smart home").

11. A method for monitoring and managing the monitoring and management of electrical power consumption by household consumers comprising connecting household consumers to the power grid using switching means to form medium priority circuits by series connection of contact groups of different relays, setting a maximum power consumption limit (Pmax), equipping consumers with power management means, monitoring the instantaneous total power (current) consumption, setting priorities for electrical consumers, transmitting monitoring information to a microcontroller, power management of consumers, WHEREIN in order to switch the single-phase medium priority consumers connected to a three-phase power grid a series connection of contact groups (contacts) of two independent power relays is used to control a low priority load by opening a normally closed contact and the a high priority load by switching the power supply of the load between two phases, respectively, wherein the relay to be used is selected by jumpers providing either the independent operation of both relays to implement one switching circuit between the high priority load and low priority load phases or a series connection of their contacts for the medium priority consumer switching.

12. System as recited in claim 11, further comprising the electric power grid in a house connected via switching and measuring means to an external power source, electrical consumers connected to said grid and being a workload for the power source, means for measuring the current (power) consumed by consumers, means for controlling the electrical load of consumers intended to keep the power consumption of consumers in the grid within the maximum power limits, devices for transmitting monitoring information and controlling the transmission periodicity of instantaneous consumption current (power) values, WHEREIN further comprising switching means for single-phase medium priority consumers using power relays connected to the phase wires of a three-phase power grid, wherein each consumer is series connected using contact groups of two independent power relays, one of which comprises a normally closed contact intended to disconnect a low priority consumer, and the second relay comprises a contact for switching the power supply of the high priority consumer between two phases, wherein the relays are equipped with jumpers to select the use of the said relays to form a control circuit of either one medium priority consumer, or one low priority consumer and one high priority consumer.

13. A method for monitoring and management of electrical power consumption by household consumers comprising connecting household consumers to the power grid using switching means, setting a maximum power consumption limit (Pmax), equipping consumers with power management means, monitoring the instantaneous total power (current) consumption, setting priorities for electrical consumers, transmitting monitoring information to a microcontroller, power management of consumers, WHEREIN the microcontroller digitizes the measured instantaneous current values in the phase wires and neutral wire with a predefined increment providing the current measuring threshold (ADC capacity of 12...16 bits) not lower than the actuation threshold of current disconnecting devices of switching means that perform the smart RCD function and provide, using the software package, detection of leakage currents in the ground wire by digital filtering of current pickups in the phase wires and the microcontroller measures and digitizes the instantaneous values of in the phase wire voltage to in relation to ground , calculates, using averaging and correlation of voltages and currents, the presence of small leakage to the ground by inequality to zero of the sum of currents of the phase and neutral wires at the controller input, then, knowing the consumer load distribution by phases and instantaneous values of consumption currents, a consumer with leakage to ground is found, after that it is predicted if a allowability of this leaking consumer to be disconnected depending on its priority, if it is powered by a low or medium priority circuit, it is disconnected a message generation to the user (SMS), for example, a text message to a mobile phone, e-mail, message via web-applications and signal (sound or light) to the controller devices, additionally before decision to notify about a fault or disconnecting a consumer, the monitoring and forecast of the leakage development are carried out and when an continuing increase in leakage is detected or a critical value is reached (the actuation threshold), a decision is automatically made to disconnect the consumer and (or) notify the user, in a predetermined time interval upon disconnection, attempts are made to restore the power supply to the disconnected consumer, additionally if its normal operation is restored, the controller cancels its emergency status and sends a corresponding message to the user, and if the emergency status continues, a repeated disconnection is performed followed by a message to the user, additionally the interval between repeated switching on of the faulty consumer with each subsequent switching on increases, in a case of a chronic but small leak with a value less than the response threshold is noticed for a certain consumer, then the user is informed about it and the consumer is assigned the status of potentially hazardous until the consumer restores a safe mode of operation, then the hazardous status is removed but the user is sent a message with warning that this consumer has ceased to show a leak but this may be due to its inclusion in a non-grounded electrical circuit and this device's body may be under voltage in which case, this consumer potential leakage status will be monitored at regular predefined intervals.

14. System as recited in claim 13, further comprising the electric power grid in a house (home) connected via switching and measuring means to an external power source, electrical consumers connected to the said grid and being a load for the power source, means for measuring the current power consumed by consumers, means for controlling the load of consumers intended to keep the power consumption of consumers in the grid within the maximum power limit, devices for transmitting monitoring information and controlling the transmission periodicity of instantaneous consumption current power values, wherein the extra high priority consumers are optionally connected to the guaranteed voltage node, high priority consumers are connected to the grid via power relays allowing switching the grid phases, medium priority consumers are connected to the grid using power relays allowing disconnecting from the grid to defer their operation to another time during peak periods and high hourly power rates according to a flexible set schedule and/or switch the grid phases, low priority consumers are connected to the grid via power relays disconnecting them during peak periods and high hourly power rates, consumers multiphase switching means and consumers are connected to a microcontroller that controls the loads and load phase distribution and time shift, the microcontroller is equipped with a multichannel analog-to-digital converter measuring currents in the phase wires of consumers and phases of feeders including external current sensors connected via connectors and located on the phase wires of the feeder, neutral wire on the lines of home microgeneration power source and internal inductive or Hall-effect current sensors as part of power circuit boards, and dividers on the feeder phase lines and neutral wire for measuring voltage to ground, equipped with an electronic interface for external access via the Internet to monitoring information and remote control/turn on/off loads of heating, air conditioning and hot water supply systems, comprises external auxiliary devices with wireless sensors that detect open doors and windows in order to eliminate heat losses and improve power consumption taking into account rooms habitability and predict changes in electrical heating loads.

15. A system as recited in claim 14, further comprising a microcontroller that has analog inputs to obtain measured voltage and current values, equipped with an ADC of sufficient throughput and capacity (0.1...1.0 MCounts/sec; 12...16 bits), has a hardware interface for Internet communication and smart sensor (WiFi / Bluetooth LowEnergy) and home automation networks (smart home), e.g. KNX/EIB (European Installation Bus) to receive smart home messages in order to accumulate statistics on the consumer operations.

16. A system as recited in claim 14, further comprising non-invasive inductive current sensors for external measurements and linear Hall-effect current sensors for measuring currents on the relay board.

17. A system as recited in claim 14, further comprising a controller assembly including power and control parts separated from each other at a safe distance preventing breakdown if insects getting into the space between boards or fault by locating thereof on different levels (boards) of two-level assembly where a relay board with Hall-effect sensors and inductive sensor level converters is located in the lower part of a dielectric plastic housing adapted to mounting on a DIN rail, the controller board is located in the upper part, wherein a three-phase four-wire power feeder is inserted into the relay board so that feed lines pass through the board, from which the feed lines of low priority consumers are outgoing through the normally closed contacts of the relay, and the lines of high priority consumers are grouped two per phase allowing switching one of them to the next phase, and the other one to the previous phase.

FIG. 1

EP 4 087 081 A1

R

S

T

N

Switching to one phase

.K1

K2

K3

Load

## FIG. 2

$F_2$

$F_1$

0

$F=F_2$

$F=F_1+(F_2-F_1)(P-P_{пик})/(P_{max}-P_{пик})$

$P_{пик}$

$P_{max}$

## FIG. 3

R
S
T

Protective shutoff devices

Current sensor

High priority consumer

High priority consumer

Medium priority consumer

Low priority consumer

a) Forward phase switching

b) Reverse phase switching

c) Phase shift switching and disconnection by normally closed contact

d) Disconnection

FIG. 4

**Reserve power monitoring** $(\Delta P = P_{max} - P)$ where $P_{max}$ is a maximum power consumption limit from the centralized grid;

P - is a instantaneous total power consumption of the household consumers.

When the power consumption P exceeds the peak value $P_{peak}$ the peak mode of power consumption is set increasing frequency of monitoring information control and transmission to the microcontroller

**Power management in basic mode**

In the basic mode when $\Delta P \geq (P_{max} - P_{peak})$ periodic monitoring is performed at a frequency F and information is periodically transmitted from the sensors for monitoring instantaneous current, voltage values, load balance between phases by pairwise comparison of phase and neutral wire currents and load balancing in phases by disconnecting both groups of consumers and individual consumers, depending on priorities and forward or reverse phase switching of consumers or groups of consumers.

**Power management in peak mode** When the power reserve $\Delta P$ in the home grid is below the value $(P_{max} - P_{peak})$ the peak mode is set wherein:

$$\Delta P \leq (P_{max} - P_{peak}).$$

In the peak mode of power consumption, the frequency of transmission of instant monitoring control parameters is multiplied compared with the basic mode up to the value $F_2$ or values determined by the formula $F = (F_2 - F_1)(P - P_{peak})/(P_{max} - P_{peak})$. At the same time, complete monitoring of instantaneous power level and quality parameters and power consumption management of consumer groups in the home are carried out taking into account their priorities

# FIG. 5

EP 4 087 081 A1

Current sensor

Protective shutoff devices

R

S

Air conditioners

T

N

Power grid connection unit

Air conditioner connection unit

Load mode signaling unit

Communication and Internet TCP/IP unit

High priority consumer connection unit

Low priority consumer connection unit

Cloud interface EIB/KNX connection unit

FIG. 6

FIG. 7

FIG. 8a

FIG. 8b

Top view of power board with components

R Aux1 S      Gnd Aux2 T      Aux3 Nin Nout

H1 H4 A4 S   L1 Lh4 H2 H5 A5 T   L2 Lh5 H3 H6 A6 R   L3 Lh6

FIG. 9a1

SECTIONS

FIG. 9a2

Power board printed circuits, component side

FIG. 9b

EP 4 087 081 A1

Power board, solder side

FIG. 9c

K2    S4

S1    K1

S5

S2

K4    Lh4

K3    L1

S3    S

H1    A4

H4

FIG. 10

## INTERNATIONAL SEARCH REPORT

| International application No. |
| --- |
| PCT/RU 2020/000536 |

### A. CLASSIFICATION OF SUBJECT MATTER
H02J 3/00 (2006.01); G16Y 20/30 (2020.01)

According to International Patent Classification (IPC) or to both national classification and IPC

### B. FIELDS SEARCHED

Minimum documentation searched (classification system followed by classification symbols)
H02J 3/00, H02J 1/08, G16Y 20/30

Documentation searched other than minimum documentation to the extent that such documents are included in the fields searched

Electronic data base consulted during the international search (name of data base and, where practicable, search terms used)
PatSearch (RUPTO internal), USPTO, PAJ, K-PION, Esp@cenet, Information Retrieval System of FIPS

### C. DOCUMENTS CONSIDERED TO BE RELEVANT

| Category* | Citation of document, with indication, where appropriate, of the relevant passages | Relevant to claim No. |
| --- | --- | --- |
| A | RU 2242832 C2 (AISA VALERIO) 27.07.2003 | 1-17 |
| A | US 7388364 B2 (SIEMENS AG OSTERREICH) 17.06.2008 | 1-17 |
| A | WO 2013/109169 A2 (OBSCHESTVO S OGRANICHENNOI OTVETSTVENNOSTJU «KLASTERVIN») 25.07.2013 | 1-17 |

☐ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>24 February 2021 (24.02.2021) | Date of mailing of the international search report<br>04 March 2021 (04.03.2021) |
| Name and mailing address of the ISA/<br>RU<br><br>Facsimile No. | Authorized officer<br><br><br>Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100312414 A
- US N700295 A
- RU 2341859
- RU 2473916

- RU 2200364
- RU 2442263
- RU 2242832